# EUROPÄISCHE PATENTSCHRIFT

(11) **EP 1 837 202 B1**
(45) Veröffentlichungstag und Bekanntmachung des Hinweises auf die Patenterteilung: **27.02.2013**
(21) Anmeldenummer: 06005698.3
(22) Anmeldetag: 21.03.2006
(51) Int. Cl.: B44B 5/02, B44B 5/00

(54) **Herstellverfahren für einen nahtlosen Prägezylinder**
Method for manufacturing a seamless embossing cylinder
Procédé de fabrication d'un cylindre de gaufrage continu

(43) Veröffentlichungstag der Anmeldung: 26.09.2007
(73) Patentinhaber: Hueck Folien Ges.m.b.H., 4342 Baumgartenberg (AT)
(72) Erfinder: Kuchenreuther, Hubert, 92637 Weiden (DE); Lauterbach, Otto, 92637 Weiden (DE); Reich, Peter, 92712 Pirk (DE)
(74) Vertreter: Landgraf, Elvira

(56) Entgegenhaltungen:
- WO-A-00/20217
- WO-A-00/61357
- WO-A-02/20268
- WO-A-02/20274
- WO-A-97/01442
- DE-A- 3 332 460
- DE-A- 10 324 936
- US-A- 4 250 135
- US-A- 5 483 890

## Beschreibung

Die Erfindung betrifft ein Verfahren zur herstellung eines; nahtlosen Prägezylindes mit nahtlosen Originalen 3D-Strukturen.

### Stand der Technik

Aus der WO 00/20217 ist eine Stichtiefdruckplatte zum vollflächigen Drucken zusammenhängender Druckbildbereiche bekannt, wobei in den gravierten farbaufnehmenden Bereichen Trennstege vorhanden sind, die derart gestaltet sind, dass sie keine Flächen in Höhe der Druckplattenoberfläche aufweisen.

In WO 02/20268 ist ein Verfahren zur Herstellung von Stichtiefdruckplatten beschrieben, wobei die Linienstrukturen mittels eines Computerprogramms erzeugt und bearbeitet werden.

Aus der WO 02/20274 sind Datenträger mit einem Sicherheitselement bekannt, das wenigstens in einem Teilbereich eine im nicht farbführenden Stichtiefdruck mit Hilfe einer ebenfalls beschriebenen Stichtiefdruckplatte erzeugte Halbtonblindprägung aufweist.

DE10324936A1 zeigt Prägezylinder, der bergits nahtlos ausgeführt ist, jedoch mit einer 2D/3D Simulation den originalen 3D Prägecharakter nur nachempfindet.

Aus DE-A 3332460 ist ebenfalls Prägewerkzeug zum kontinuierlichen Prägen von Folien bekannt, das nahtlos ausgeführt ist und dessen Oberfläche derart mit Rillen versehen ist, dass ein Muster aus Tetraedern entsteht. WO-A-97/01442 offenbart eine Prägewalze, die einen zentralen Grundkörper und in Umfangsrichtung sowie in Axialrichtung voneinander beabstandete Prägestempel aufweist. US-A 5483890 offenbart einen nahtlosen Prägezylinder zur Herstellung texturierter Wand- oder Bodenbeläge.

Bisher bekannte Verfahren zur Herstellung von Prägezylindern mit unterschiedlicher endloser Bildinformation für den Tiefdruck, wie Muletieren oder Rekombinieren, erlauben die Herstellung von Prägezylindern, die allerdings Nähte und Stöße aufweisen, oder über eine so genannte 2D/3D Simulation einen 3D ähnlichen nahtlosen Prägezylinder erzeugen.

Ein Prägezylinder ist aber ein endloses Druckwerkzeug und sollte dementsprechend auch endlose Strukturen aufweisen die sich darin auszeichnen in einer originalen 3D Form auf dem Prägezylinder befinden, die mit den herkömmlichen Verfahren nicht erzeugbar sind.

### Aufgabenstellung

Aufgabe der Erfindung war es ein Verfahren zur Herstellung eines nahtlosen Prägezylinders mit originalen 3D-Strukturen bereitzustellen.

### Beschreibung der Erfindung

Gegenstand der Erfindung ist daher ein Verfahren zur Herstellung eines nahtlosen Prägezylinders, wobei ein entsprechendes 8bit Graustufenbild über ein Erfassungsgerät in ein Bildverarbeitungsprogramm eingelesen wird, mit den entsprechenden Formen über eine geeignete Software verbunden wird und dadurch originale 3D-Strukturen in Form eines höhenmodulierten Volumenmodells entstehen, dadurch gekennzeichnet, dass die originalen 3 D-Strukturen anschließend mittels eines Laser- oder Elektronenstrahlsystems auf einen vorbereiteten Zylinder energetisch eingearbeitet werden, wobei die energetische Einarbeitung durch direktes Entfernen und/oder Verdampfen von Metall, Keramik oder sonstiger Werkstoffe mit Hilfe eines Laser- oder Elektronenstrahlsystems erfolgt.

Vorteil einer originalen 3D Struktur ist die tiefer ausgeprägte Plastizität der abgeformten Elemente.

Unter einer originalen 3D Struktur (3D als Abkürzung für dreidimensionale geometrische Dimension) wird eine Struktur verstanden, die als Objekt mit 3 Definitionswerten beschrieben ist. Bei originalen 3D Strukturen handelt es sich um Objekte mit einem zusätzlich zu den 2D nur flächenmodulierten Oberflächen, eine weitere Größe der Höhemodulation eines Volumenmodells. Eine reine 2D Struktur ist nur flächenmoduliert.

Zur Herstellung eines originalen 3D Prägezylinders wird ein Verfahren verwendet, bei dem in einen entsprechenden Zylinder mit Hilfe der Laser- oder Elektronenstrahltechnologie entsprechend den auf der geprägten Bahn gewünschten Mustern, Bildern, Linien, Buchstaben und Formen, entsprechende Formen in den Prägezylinder energetisch eingebracht werden.

Dazu wird in einem ersten Schritt ein entsprechendes Datenfile generiert. Hierzu wird das entsprechende Graustufenbild beispielsweise ein 8 bit Graustufenbild über ein entsprechendes Erfassungsgerät, beispielsweise einen Scanner, wie einen EBV-Scanner, wie z.B. Hell Graphics Systems S3300 in ein elektronisches Bildverarbeitungsprogramm wie z.B. Hell Linocolor oder Adobe Photoshop eingelesen.

Das entsprechende Graustufenbild kann aber auch elektronisch mittels geeigneter Software, z.B. Adobe Illustrator, Corel Draw, Freehand erstellt werden.

Das gewünschte Graustufenbild wird anschließend in einem geeignetem Softwareprogramm, beispielsweise in Barco Fortuna, mit den entsprechenden geometrischen Formen, z.B. Gulliochen, Sinus-Waves, Stripes verbunden, oder mit einem Bildbearbeitungsprogramm z.B. Adobe Photoshop im Graustufenmodus 8bit bearbeitet.

Bei der Bearbeitung des originalen 3D Prägefiles sind die einzelnen Tiefenlevel und Profile fest der Systemvariablen 0 bis 255 entsprechend 8bit zugeordnet. Die Definition kann entweder positiv tiefste, Prägetiefe 255 oder negativ tiefste Prägetiefe 0 erfolgen. Das fertige originale 3D Prägefile wird im 8bit Graustufenmodus z.B. TIFF Format gespeichert. Es kann aber auch jedes andere 8bit Pixel Grafik Format verwendet werden.

Das auf diese Weise hergestellte Bild wird nun in einem entsprechenden Laser - oder Elektronenstrahlsystem auf einen vorbereiteten Zylinder energetisch eingearbeitet. Als energetische Einarbeitung wird das direkte Entfernen und/oder Verdampfen von Metall, Keramik oder sonstiger Werkstoff mit Hilfe eines Laser- oder Elektronenstrahls verstanden.

Erfindungsgemäß wird mit Hilfe eines Laser- oder Elektronenstrahls eine auf dem Zylinder, beispielsweise einem Tiefdruckzylinder mit einem Kern aus Eisenrohr mit Wandstärke 20 mm, und folgenden Schichten: 5-7[mu]m Nickelschicht, 300[mu]m Kupferschicht; in die vorhandene Top-Schicht mit den entsprechenden Mustern, Formen, Linien, Buchstaben in Form des vorher definierten Rasters eingebracht, wobei die Zylinderoberfläche auch andere für den Prägeprozess geeignete Oberflächen haben kann, wie z.B. Metalle wie Zink, Nickel, Chrom, Stahl undalle Arten von Keramik, Gummi und Hartgummi.

Der zu bearbeitende Zylinder wird z.B. in ein geeignetes Lasersystem der Fa. Dätwyler Laserstar oder Fa. Hell - Kiel "Kupferlasersystem für Tiefdruckzylinder", (Laser- oder Elektronenstrahlsysteme von anderen Herstellern) eingelegt.

Das in der elektronischen Bildverarbeitung vorbereitete originale 3D File wird auf den Bearbeitung/Maschinenrechner im TIFF Format Graustufen 8bit aufgespielt. Anhand der Maschinenparameter werden dem im File zugeordneten Systemlevels einzelne Laserleistungen zugeordnet. Z.B. Systemlevel 0 = 0 Watt; Systemlevel 128 = 400 Watt; Systemlevel 255 = 800 Watt. Es können aber auch alle beliebigen Leistungen entsprechend der später gewünschten Prägetiefe definiert werden. Die Definition der Leistungsparameter zu den Systemlevels kann linear oder logarithmisch erfolgen. In einem durchgeführten Versuch auf eine Kupferoberfläche wurde eine lineare Systemlevelzuordnung gewählt, bei der eine Prägetiefe bei Level 255 mit 3µm definiert wurde.

Entsprechend dem elektronischen Bilddatenbestandes des originalen 3D Datenfiles wurde nun die Strahlintensität moduliert und dadurch verschiedene Modulationstiefen erzeugt.
Der in dem Versuchsvorgang eingesetzte Kupferzylinder wirkt nach dem Laservorgang stumpf und optisch dunkel. Eine Abformung bzw. Prägung der Oberfläche führt daher auch zu einem sehr schlechten Abformergebnis. Eine Oberflächenbehandlung mit dem elektrolytischen bzw. chemischen Glänzen veredelt die Abformstruktur und erzeugt eine brillante Oberfläche.

Das anodische Glänzen oder Polieren bildet eine wertvolle Ergänzung der verschiedenen Polierverfahren, es stellt jedoch keinen universellen Ersatz anderer Verfahren dar. Es eignen sich weder alle Metalle dafür, noch können mit diesem Verfahren alle gewünschten Oberflächenprofile hergestellt werden. Diese einschränkenden Feststellungen sind wichtig, weil nur durch Absteckung der Grenzen der Anwendungsmöglichkeit Misserfolge und Enttäuschungen vermieden werden können. Das Wesen des anodischen Polierens, auch elektrolytisches Polieren oder Elektropolieren, besteht darin, dass die zu polierende Oberfläche als positiver Pol, Anode, in einer geeigneten Lösung, dem Elektrolyten, der auf das zu behandelnde Metall speziell abgestimmt sein muss, mehr oder minder lange, meist einige Minuten bis zu einer Viertelstunde, behandelt wird. Der Elektropoliervorgang geht demnach umgekehrt wie die galvanische Metallabscheidung an der Kathode vor sich. Das anodisch geschaltete Metall löst sich im Elektrolyten auf, doch geht die Auflösung an den Mikroerhöhungen der Oberfläche stärker vor sich als in den Vertiefungen. Dadurch erfolgt eine allmähliche Einebnung und Glättung im Mikrobereich, die bis zu Hochglanz führen kann.

Voraussetzung für den Erfolg des Elektropolierens ist, dass ein polierbares Metall vorliegt und dass der darauf abgestimmte Elektrolyt angewandt wird. Die meisten homogenen Metalle und Legierungen lassen sich gut polieren. So ist das Verfahren z.B. besonders geeignet für nichtrostende Chrom-Nickel-Stähle, für viele Hartmetalle, für Reinaluminium und nicht zu hoch legiertes Aluminium, für kupferreiches Messing und andere Kupferlegierungen, für Edelmetalle. Verschiedene der genannten Metalle sind mechanisch nur schwierig auf guten Hochglanz zu bringen. Bei heterogenen, mehrphasigen Systemen, wie z.B. Kohlenstoffstähle, zinkreiches oder bleihaltiges Messing, Aluminiumgusslegierungen, werden die einzelnen Phasen in verschiedenem Masse angegriffen, so dass es bei diesen Metallen meist nicht gelingt, durch anodisches Polieren einwandfreien Hochglanz zu erzielen. Die Erzielung von Seidenglanz ist hingegen oft möglich.

Der bevorzugte Angriff auf die aus der Oberfläche herausragenden Stellen führt dazu, dass am Werkstück vorhandene Grate rasch abgetragen werden. Das Elektropolieren eignet sich daher vorzüglich zum Entgraten von Werkstücken, insbesondere solchen, die auf andere Weise nur schwierig zu entgraten sind oder die dazu viel Handarbeit erfordern würden. Für das Entgraten spielt in der Regel die Zusammensetzung des Grundmetalls, einphasig oder mehrphasig, keine Rolle und auch an sich schlecht polierbare Metalle und Legierungen lassen sich gut elektrolytisch entgraten.

Beim anodischen Polieren erfolgt zum Unterschied von mechanischen Verfahren keinerlei mechanische Einwirkung auf die Oberfläche des Werkstückes; es werden vielmehr oberflächliche Schichten, die durch eine vorhergegangene mechanische Behandlung verformt wurden und innere Spannungen erhielten, beim Elektropolieren abgelöst, so dass das unveränderte Grundgefüge des Werkstoffes oberflächlich in Erscheinung tritt.

Diese Eigenart des anodischen Polierens bewirkt auch, dass etwa vorhandene Oberflächenfehler, wie Lunker, Riefen, Risse, Einschlüsse, nicht zugeschmiert werden, wie es beim mechanischen Polieren der Fall ist, sondern dass diese Fehler nach der anodischen Behandlung eher verstärkt in Erscheinung treten. Dies ist jedoch eine oft sehr wertvolle Eigenschaft dieser Verfahren. Die beim mechanischen Polieren zugeschmierten oder sonst wie verdeckten Fehlstellen täuschen nur eine in der Tat nicht vorhandene einwandfreie Oberfläche vor, die aber sehr oft bei nachfolgender Behandlung, z.B. in galvanischen Bädern, diese Fehler eindeutig erkennen lässt. Durch das anodische Polieren kann Ausschussware als solche erkannt werden, ehe noch weitere Arbeit darauf verwendet wurde. Aus diesem Grunde wird das Verfahren auch vielfach zur Fehlersuche eingesetzt. (Als Beispiel von vielen sei die Prüfung von Turbinenschaufeln für Flugzeugmotoren auf Fehlerfreiheit genannt.)

Während des anodischen Poliervorganges wird Metall bevorzugt an den aus der Oberfläche herausragenden Stellen aufgelöst. Dadurch findet eine fortschreitende Glättung und Einebnung statt. Makrorauhigkeiten oder - unebenheiten bleiben hingegen unberührt. Es ist daher nicht möglich, durch anodisches Polieren etwa eine ideal ebene Fläche oder sonst ein bestimmtes geometrisches Profil exakt herzustellen. Wird eine solche Oberfläche gefordert, so ist das Makroprofil durch vorherige mechanische Behandlung, auch mechanisches Schleifen und Polieren, herzustellen und erst die Beseitigung der dann noch vorhandenen Mikrorauhigkeiten und die Herstellung von Hochglanz geschieht durch Elektrolyse.

Wird demnach eine leicht wellige, matte Oberfläche elektropoliert, so bleibt die Welligkeit im Wesentlichen erhalten, auch wenn Hochglanz erreicht wird. Wird die gleiche Ausgangsoberfläche mechanisch geschliffen, bzw. poliert, so wird die Welligkeit beseitigt, aber die resultierende Oberfläche zeigt bei genügend starker Vergrößerung stets die Schleif- oder Polierriefen entsprechend der Größe des angewandten Schleifkornes.

Anodisch polierte Oberflächen sind somit vor allem gekennzeichnet durch das Fehlen von Mikrorauhigkeiten. Daraus ergeben sich verschiedene wertvolle Eigenschaften dieser Oberflächen, die technisch genützt werden: Hoher Glanz und bestes Reflexionsvermögen (Optik, dekorative Verwendung), niedriger Reibungskoeffizient, daher geringere Reibungsverluste und verminderte Reibungswärme und geringerer Reibungsverschleiß (Zahnräder, Lager, Wellen, Kolben, Kolbenringe), geringeres Adsorptionsvermögen und Absorptionsvermögen für Gase und Flüssigkeiten (Vakuumtechnik), es ist auch überall dort bedeutsam, wo besonderer Wert auf große Reinheit und Reinigungsmöglichkeit gelegt wird (medizinische Geräte, Krankenhauseinrichtungen, Färbebottiche, Druckwalzen).

Gegenüber mechanischen Verfahren hat das Elektropolieren einige sehr wertvolle Vorteile: es erfordert keine teure Handarbeit qualifizierter Kräfte, sämtliche beim mechanischen Polieren oft bestehenden Unfall- und Gefahrenquellen fallen weg, auch komplizierte Formen und schwer polierbare Metalle lassen sich mühelos elektropolieren, es gibt keine Staubbelästigung.

Als Nachteile sind zu erwähnen die nicht universelle Anwendbarkeit, das Hantieren mit oft sehr konzentrierten Säuren, bzw. generell die nasse Bearbeitung in Betrieben, die sonst keine Nassbehandlung anwenden, verhältnismäßig teure Anlagen, das Anfallen von Abwässern, die besonders zu behandeln sind, wofür eigene Anlagen benötigt werden.

Die Verfahren lassen sich voll automatisieren, auch die Fertigung von Kleinteilen in großen Stückzahlen in besonders dafür entwickelten Geräten ist möglich.

Das chemische Glänzen unterscheidet sich von den elektrolytischen Verfahren dadurch, dass keine äußere Stromquelle erforderlich ist. Die Abtragung der Oberfläche geschieht jedoch in gleicher Weise wie beim anodischen Polieren. An Stelle der unmittelbaren Wirkung des elektrischen Stromes werden entsprechend aggressive Chemikalien verwendet, die den gelenkten Abbau der Oberfläche, das heißt, naturgemäß laufend verbraucht und sind ständig zu ergänzen. Auch diese Lösungen müssen auf jedes zu behandelnde Metall besonders abgestimmt sein, das hier eher noch etwas kritischer ist als bei den anodischen Polierverfahren. Da äußere Stromquellen fehlen, sind die Anlagekosten erheblich geringer als für elektrolytische Verfahren. Die laufenden Chemikalienkosten, die an Stelle der Stromkosten treten, sind hingegen meist höher.

Die Beschaffenheit der chemisch geglänzten Oberflächen ist im Prinzip die gleiche wie von anodisch geglänzten. Die Verfahren werden im Hinblick auf den Chemikalienverbrauch vor allem dort eingesetzt, wo nur geringe Materialmengen abzulösen sind. Wegen der außerordentlich einfachen Handhabung und der billigen Anlagen werden sie jedoch im großen Umfang technisch angewandt. Als ältestes Verfahren dieser Reihe ist das Glanzbrennen von Messing und anderen Kupferlegierungen zu nennen. Neuerdings werde besonders Leichtlegierungen auf diese Weise geglänzt.
Anstelle von Polieren sind auch weitere Oberflächenveredelungsschritte wie verchromen und vernickeln möglich, die der gewünschten Qualität der Abformung angepasst sein können.

Der erfindungsgemäß hergestellte Prägezylinder weist ein definiertes Oberflächenrelief mit unterschiedlichen originalen 3D Strukturen in unterschiedlichen Ausrichtungen und Tiefen auf.

Der erfindungsgemäß hergestellte Prägezylinder ist nahtlos und kann daher zur Herstellung geprägter bahnförmiger Materialien mit endlosen Beugungsstrukturen verwendet werden.

Als bahnförmige Materialien kommen beispielsweise Trägerfolien vorzugsweise flexible Kunststofffolien, beispielsweise aus PI, PP, MOPP, PE, PPS, PEEK, PEK, PEI, PSU, PAEK, LCP, PEN, PBT, PET, PA, PC, COC, POM, ABS, PVC in Frage. Die Trägerfolien weisen vorzugsweise eine Dicke von 5-700 µm, bevorzugt 5-200 µm, besonders bevorzugt 5-50 µm auf.

Ferner können als Trägersubstrat auch Metallfolien, beispielsweise Al-, Cu-, Sn-, Ni-, Fe- oder Edelstahlfolien einer Dicke von 5-200 µm, vorzugsweise 10 bis 80 µm, besonders bevorzugt 20-50 µm dienen. Die Folien können auch oberflächenbehandelt, beschichtet oder kaschiert beispielsweise mit Kunststoffen oder lackiert sein.

Ferner können als Trägersubstrate auch Papier oder Verbunde mit Papier, beispielsweise Verbunde mit Kunststoffen mit einem Flächengewicht von 20-500 g/m², vorzugsweise 40-200 g/m², verwendet werden.

Ferner können als Trägersubstrate Gewebe oder Vliese, wie Endlosfaservliese und Stapelfaservliese, die gegebenenfalls vernadelt oder kalandriert sein können, verwendet werden. Vorzugsweise bestehen solche Gewebe oder Vliese aus Kunststoffen, wie PP, PET, PA und PPS, es können aber auch Gewebe oder Vliese aus natürlichen, gegebenenfalls behandelten Fasern, wie Viskosefasern eingesetzt werden. Die eingesetzten Gewebe oder Vliese weisen ein Flächengewicht von etwa 20 g/m² bis 500 g/m² auf.

Die Trägersubstrate können zusätzlich eine Lackschicht aufweisen, die unstrukturiert oder strukturiert sein kann. Die Lackschicht kann beispielsweise eine haftende Lackschicht oder eine releasefähige Transferlackschicht sein, sie kann durch Strahlung, beispielsweise UV-Strahlung, thermisch oder reaktiv vernetzt oder vernetzbar sein und zusätzliche Eigenschaften wie z.B. kratzfeste und/oder antistatische Ausrüstung oder chemische Beständigkeit besitzen. Geeignet sind sowohl wässrige als auch lösungsmittelhaltige Lacksysteme, insbesondere auch Lacksysteme auf Basis Polyester - Acrylat, PET-Acrylat, Urethan-Acrylat, PVC, PMMA oder Epoxyacrylat.

Die einzelnen Schichten können durch bekannte Verfahren, beispielsweise durch Bedampfen, Sputtern, Drucken (Tief-, Flexo-, Sieb-, Offset-, Digitaldruck), Sprühen und Galvanisieren aufgebracht werden.

Ferner können als Substrate textile Materialien wie Gewebe oder Vliese, wie Endlosfaservliese und Stapelfaservliese, die gegebenenfalls vernadelt oder kalandriert sein können, verwendet werden. Vorzugsweise bestehen solche Gewebe oder Vliese aus Kunststoffen, wie PP, PET, PA und PPS, es können aber auch Gewebe oder Vliese aus natürlichen, gegebenenfalls behandelten Fasern, wie Viskosefaser-, Hanf- oder Kenafvliese und -gewebe bzw. deren Mischungen mit Kunststofffasern eingesetzt werden. Die Trägersubstrate weisen zur Herstellung der Beugungsstrukturen eine entsprechende Beschichtung, vorzugsweise eine strahlungshärtbare Beschichtung auf.

Die Abformung der gewünschten Beugungsstruktur kann dann mittels des erfindungsgemäß hergestellten Prägezylinders auf jede bekannte Weise erfolgen.

Vorteilhafterweise kann dabei aber ein Verfahren angewendet werden, bei dem in einem ersten Schritt ein Trägersubstrat bereitgestellt wird, in einem zweiten Schritt dieses Trägersubstrat in einem Beschichtungsverfahren mit einem strahlungshärtbaren Lack beschichtet wird, in einem dritten Schritt dieser Lack bis zum Gelpunkt durch Anregung mit Strahlung einer definierten Wellenlänge vorgehärtet wird, und gleichzeitig die Abformung der Oberflächenstruktur durchgeführt wird, in einem vierten Schritt die weitere Aushärtung (Haupthärtung) des strahlungshärtbaren Lacks durch Anregung Strahlung einer zum Vorhärtungsschritt unterschiedlichen Wellenlänge durchgeführt, worauf eine Nachhärtung und gegebenenfalls weitere Beschichtungs- bzw. Veredelungsschritte durchgeführt werden.

Das Trägersubstrat wird in einem Beschichtungsverfahren wie beispielsweise einem Siebdruck-, Tiefdruck- oder Flexodruckverfahren mit einem strahlungshärtbaren Lack beschichtet. Die Beschichtung kann selektiv oder vollflächig erfolgen.

Der strahlungshärtbare Lack kann beispielsweise ein strahlungshärtbares Lacksystem auf Basis eines Polyester-, eines Epoxy- oder Polyurethansystems das 2 oder mehr verschiedene, dem Fachmann geläufige Photoinitiatoren enthält, die bei unterschiedlichen Wellenlängen eine Härtung des Lacksystems in unterschiedlichem Ausmass initiieren können. So kann beispielsweise ein Photoinitiator bei einer Wellenlänge von 200 bis 400 nm aktivierbar sein, der zweite Photoinitiator dann bei einer Wellenlänge von 370 bis 600 nm aktivierbar. Zwischen den Aktivierungswellenlängen der beiden Photoinitiatoren sollte genügend Differenz eingehalten werden, damit nicht eine zu starke Anregung des zweiten Photoinitiators erfolgt, während der erste Photoinitiator aktiviert wird. Der Bereich, in dem der zweite Photoinitiator angeregt wird, sollte im Transmissionswellenlängenbereich des verwendeten Trägersubstrats liegen. Für die Haupthärtung (Aktivierung des zweiten Photoinitiators) kann auch Elektronenstrahlung verwendet werden.

Als strahlungshärtbarer Lack kann auch ein wasserverdünnbarer Lack verwendet werden. Bevorzugt werden Lacksysteme auf Polyesterbasis.

Die Abformung der Oberflächenstruktur, also der Diffraktions-, Beugungs- oder Reliefstruktur erfolgt beispielsweise bei kontrollierter Temperatur mittels einer Matrize oder unter Verwendung des erfindungsgemäß hergestellten Prägezylinders in die strahlungshärtbare Lackschicht, die durch Aktivierung des ersten Photoinitiators bis zum Gelpunkt vorgehärtet wurde und zum Zeitpunkt der Abformung sich in diesem Stadium befindet.

Wird ein wasserverdünnbarer strahlungshärtbarer Lack verwendet kann gegebenenfalls eine Vortrocknung vorgeschaltet werden, beispielsweise durch IR-Strahler.

Die Schichtdicke des aufgebrachten strahlungshärtbaren Lacks kann je nach Anforderung an das Endprodukt und Dicke des Substrats variieren und beträgt im allgemeinen zwischen 0,5 und 50 µm, vorzugsweise zwischen 2 und 10 µm, besonders bevorzugt zwischen 2 und 5 µm.

Es ist aber auch die Verwendung des erfindungsgemäß hergestellten Prägezylinders in jedem anderen bekannten Prägeverfahren, also auch in bekannten thermoplastischen Prägeverfahren möglich.

Besonders vorteilhaft können mit dem erfindungsgemäßhergestellten Prägezylinder Oberflächenstrukturen für Sicherheitselemente für Wertdokumente oder Verpackungen, für Leiterplatten, für Stützstrukturen für Transistoren auf Basis von Metallen oder Halbleitern oder leitenden Polymeren, in der Mikroelektronik, für Leiterbahnen für optische Elemente, für Biochips, für Grundstrukturen für polymere Chips, für Reflektorsysteme, für Fresnelllinsen, für Mikrokanülen oder Mikrokanäle, für Lichtleiterstrukturen oder auch für dekorative Elemente in der Architektur hergestellt werden.

## Patentansprüche

1. Verfahren zur Herstellung eines nahtlosen Prägezylinders, wobei ein entsprechendes 8bit Graustufenbild über ein Erfassungsgerät in ein Bildverarbeitungsprogramm eingelesen wird, mit den entsprechenden Formen über eine geeignete Software verbunden wird und dadurch originale 3D-Strukturen in Form eines höhenmodulierten Volumenmodells entstehen, **dadurch gekennzeichnet, dass** die originalen 3 D-Strukturen anschließend mittels eines Laser- oder Elektronenstrahlsystems auf einen vorbereiteten Zylinder energetisch eingearbeitet werden, wobei die energetische Einarbeitung durch direktes Entfernen und/oder Verdampfen von Metall, Keramik oder sonstiger Werkstoffe mit Hilfe eines Laser- oder Elektronenstrahlsystems erfolgt.

2. Verfahren nach Anspruch 1, **dadurch gekennzeichnet, dass** der Zylinder anschließend mechanisch poliert wird.

3. Verfahren nach Anspruch 2, **dadurch gekennzeichnet, dass** die Zylinderoberfläche anonisch oder anodisch und mechanisch poliert wird.

4. Verfahren nach einem der vorhergehenden Ansprüche, **dadurch gekennzeichnet, dass** die Tiefenlevel der originalen 3D-Strukturen fest Systemvariablen von 0 bis 255 entsprechend 8bit zugeordnet werden.

5. Verfahren nach Anspruch 4, **dadurch gekennzeichnet, dass** die Systemvariablen einer Laserleistung zugeordnet werden und dadurch über Variation der Strahlintensität verschiedene Modulationstiefen erzeugt werden.

6. Verwendung des Prägezylinders, der gemäß einem der Ansprüche 1 bis 5 hergestellt wurde, zur Herstellung von originalen 3D-Strukturen auf beschichteten oder unbeschichteten Trägermaterialien, die für Sicherheitselemente, Verpackungen , für Leiterplatten, für Stützstrukturen für Transistoren auf Basis von Metallen oder Halbleitern oder leitenden Polymeren, in der Mikroelektronik, für Leiterbahnen für optische Elemente, für Biochips, für Grundstrukturen für polymere Chips, für Reflektorsysteme, für Fresnell-Linsen, für Mikrokanülen oder Mikrokanäle, für Lichtleiterstrukturen oder auch für dekorative Elemente in der Architektur verwendet werden.

## Claims

1. Method for manufacturing a seamless embossing cylinder, an appropriate eight-bit grey stage image being read into an image processing program via a measuring instrument, being linked to the appropriate forms via suitable software and, as a result, original 3-D structures in the form of a vertically modulated volume model being produced, **characterized in that** the original 3-D structures are subsequently machined energetically into a prepared cylinder by means of a laser or electron beam system, the energetic machining being carried out by means of direct removal and/or evaporation of metal, ceramic or other materials with the aid of a laser or electron beam system.

2. Method according to Claim 1, **characterized in that** the cylinder is subsequently polished mechanically.

3. Method according to Claim 2, **characterized in that** the cylinder surface is polished anodically or anodically and mechanically.

4. Method according to one of the preceding claims, **characterized in that** the depth of the original 3-D structures is assigned fixed system variables from 0 to 255 corresponding to eight bits.

5. Method according to Claim 4, **characterized in that** the system variables are assigned to a laser power and, as a result, different modulation depths are generated by varying the beam intensity.

6. Use of the embossing cylinder which has been produced in accordance with one of Claims 1 to 5 for manufacturing original 3-D structures on coated or uncoated substrate materials, which are used for security elements, packaging, for printed circuit boards, for supporting structures for transistors based on metals or semiconductors or conductive polymers, in microelectronics, for conductor tracks for optical elements, for biochips, for base structures for polymer chips, for reflector systems, for Fresnel lenses, for micro-cannulas or micro-ducts, for fibre-optical structures or else for decorative elements in architecture.

## Revendications

1. Procédé servant à fabriquer un cylindre de gaufrage continu, sachant qu'un appareil d'enregistrement permet de lire dans un programme de traitement d'image une image correspondante en niveaux de gris 8 bits, ladite image en niveaux de gris 8 bits étant reliée aux formes correspondantes par l'intermédiaire d'un logiciel approprié, et sachant que ce faisant des structures 3D originales apparaissent sous la forme de modèles de volume modulés en hauteur, **caractérisé en ce que** les structures 3D originales sont intégrées énergétiquement sur un cylindre préparé au moyen d'un système à faisceau d'électrons ou d'un système à faisceau laser, sachant que l'intégration énergétique est effectuée par l'élimination directe et/ou par l'évaporation de métal, de céramique ou de toute autre matière à l'aide d'un système à faisceau laser ou à électrons.

2. Procédé selon la revendication 1, **caractérisé en ce que** le cylindre est immédiatement après poli mécaniquement.

3. Procédé selon la revendication 2, **caractérisé en ce que** la surface de cylindre est polie anodiquement ou anodiquement et mécaniquement.

4. Procédé selon l'une quelconque des revendications précédentes, **caractérisé en ce que** les niveaux de profondeur des structures 3D originales sont associés de manière fixe à des variables de système allant de 0 à 255 de manière à correspondre à 8 bits.

5. Procédé selon la revendication 4, **caractérisé en ce que** les variables de système sont associées à une puissance laser, et **en ce que** la variation de l'intensité de faisceau permet de produire diverses profondeurs de modulation.

6. Utilisation d'un cylindre de gaufrage, qui a été fabriqué selon l'une quelconque des revendications 1 à 5, aux fins de la fabrication de structures 3D originales sur des matériaux de support enduits ou non enduits, qui sont utilisés pour des éléments de sécurité, des emballages, pour des cartes de circuits imprimés, pour des structures de support pour des transistors à base de métaux ou de semiconducteurs ou de polymères conducteurs, dans la microélectronique, pour des pistes conductives pour des éléments optiques, pour des biopuces, pour des structures de base pour des puces polymères, pour des systèmes de réflecteurs, pour des lentilles de Fresnel, pour des micro-canules ou des micro-canaux, pour des structures de guide de lumière ou encore pour des éléments décoratifs utilisés en architecture.
